# DEMANDE DE BREVET EUROPEEN

(11) **EP 4 391 021 A1**
(43) Date de publication de la demande: **26.06.2024**
(21) Numéro de dépôt: 23215405.4
(22) Date de dépôt: 11.12.2023
(51) Int. Cl.: H01L 21/20

(54) **PROCÉDÉ DE FABRICATION D'UN DISPOSITIF ÉLECTRONIQUE**

(30) Priorité: 19.12.2022 FR 2213810
(71) Demandeur: Commissariat à l'énergie atomique et aux énergies alternatives, 75015 Paris (FR)
(72) Inventeur: GASSILLOUD, Rémy, 38054 GRENOBLE CEDEX 09 (FR); PATOUILLARD, Julien, 38100 GRENOBLE (FR); HYOT, Bérangère, 38054 GRENOBLE CEDEX 09 (FR); DUSSAIGNE, Amélie, 38054 GRENOBLE CEDEX 09 (FR); CADOT, Stéphane, 38054 GRENOBLE CEDEX 09 (FR); CHARLES, Matthew, 38054 GRENOBLE CEDEX 09 (FR); MARTIN, François, 38054 GRENOBLE CEDEX 09 (FR); GAUTHIER, Nicolas, 38054 GRENOBLE CEDEX 09 (FR); RAYNAUD, Christine, 38054 GRENOBLE CEDEX 09 (FR)
(74) Mandataire: Cabinet Beaumont

(57) **Abrégé**

La présente description concerne un procédé comprenant les étapes successives suivantes :
a) former, sur une face d'un substrat de support (11), une première couche (13) en un matériau choisi parmi un dichalcogénure lamellaire ou un chalcogénure lamellaire comprenant un empilement de feuillets ;
b) former, par dépôt physique en phase vapeur du côté de ladite face du substrat de support, une deuxième couche (17) en un premier matériau semiconducteur III-N revêtant la première couche (13) ; et
c) effectuer un traitement thermo-chimique de la première couche (13) conduisant, dans la première couche (13), à une conversion de liaisons de van der Waals entre les feuillets de la première couche en liaisons covalentes.

## Description

### Domaine technique

La présente description concerne de façon générale les dispositifs électroniques. La présente description vise plus particulièrement les procédés de fabrication de dispositifs électroniques à base de matériaux semiconducteurs.

### Technique antérieure

Des dispositifs électroniques comprenant une région en un matériau semiconducteur, par exemple un matériau III-N, c'est-à-dire un nitrure d'un élément de la treizième colonne du tableau périodique, ont été proposés. En particulier, le nitrure d'aluminium et le nitrure de gallium sont des matériaux semiconducteurs III-N à bande interdite directe utilisés dans diverses applications telles que l'électronique de puissance, les communications radiofréquence, l'éclairage, etc.

Toutefois, la mise en oeuvre des procédés actuels de fabrication de dispositifs électroniques à base de matériaux semiconducteurs s'avère onéreuse et complexe. Ces procédés mettent par exemple en oeuvre des couches tampon (« buffer », en anglais) permettant une adaptation de paramètre de maille entre un substrat, par exemple en silicium, et la ou les couches à base de matériau semiconducteur, les couches tampon étant sujettes à des problèmes de rupture lors d'étapes de refroidissement postérieures à la formation de la ou des couches à base de matériau semiconducteur.

### Résumé de l'invention

Il existe un besoin d'améliorer les procédés existants de fabrication de dispositifs électroniques à base de matériaux semiconducteurs.

Pour cela, un mode de réalisation prévoit un procédé comprenant les étapes successives suivantes :
a) former, sur une face d'un substrat de support, une première couche en un matériau choisi parmi un dichalcogénure lamellaire ou un chalcogénure lamellaire comprenant un empilement de feuillets ;
b) former, par dépôt physique en phase vapeur du côté de ladite face du substrat de support, une deuxième couche en un premier matériau semiconducteur III-N revêtant la première couche ; et
c) effectuer un traitement thermo-chimique de la première couche conduisant, dans la première couche, à une conversion de liaisons de van der Waals entre les feuillets de la première couche en liaisons covalentes.

Selon un mode de réalisation, à l'étape c), le traitement thermo-chimique est un recuit effectué sous atmosphère réductrice.

Selon un mode de réalisation, à l'étape c), le traitement thermo-chimique est effectué sous atmosphère azotée, de préférence sous atmosphère d'ammoniac ou de diazote.

Selon un mode de réalisation, à l'étape c), le traitement thermo-chimique est effectué sous atmosphère de dihydrogène.

Selon un mode de réalisation, à l'étape c), le traitement thermo-chimique conduit en outre à une conversion de liaisons de van der Waals en liaisons covalentes entre la première couche et le substrat de support.

Selon un mode de réalisation, le premier matériau semiconducteur est le nitrure d'aluminium.

Selon un mode de réalisation, le premier matériau semiconducteur III-N est dopé, de préférence par des atomes de scandium.

Selon un mode de réalisation, le procédé comprend en outre, après l'étape c), une étape d) de formation d'une troisième couche en un deuxième matériau semiconducteur revêtant la deuxième couche, la troisième couche présentant une épaisseur supérieure à celle de la deuxième couche.

Selon un mode de réalisation, le deuxième matériau semiconducteur est un matériau semiconducteur III-V, de préférence III-N.

Selon un mode de réalisation, le deuxième matériau semiconducteur est le carbure de silicium.

Selon un mode de réalisation, le deuxième matériau semiconducteur est identique au premier matériau semiconducteur.

Selon un mode de réalisation, la troisième couche est dopée.

Selon un mode de réalisation, le procédé comprend en outre, après l'étape d), une étape e) de formation d'au moins une quatrième couche revêtant la troisième couche.

Selon un mode de réalisation, à l'étape c), le traitement thermo-chimique s'accompagne d'un traitement par plasma.

Selon un mode de réalisation, la première couche est en dichalcogénure de métal de transition, de préférence en disulfure de molybdène ou en disulfure de tungstène.

Selon un mode de réalisation, à l'étape c), le traitement thermo-chimique est effectué à une température comprise entre 300 et 1 500 °C, de préférence comprise entre 800 et 1 000 °C.

Selon un mode de réalisation, la deuxième couche présente une épaisseur comprise entre 0,15 et 50 nm, de préférence comprise entre 1 et 6 nm.

### Brève description des dessins

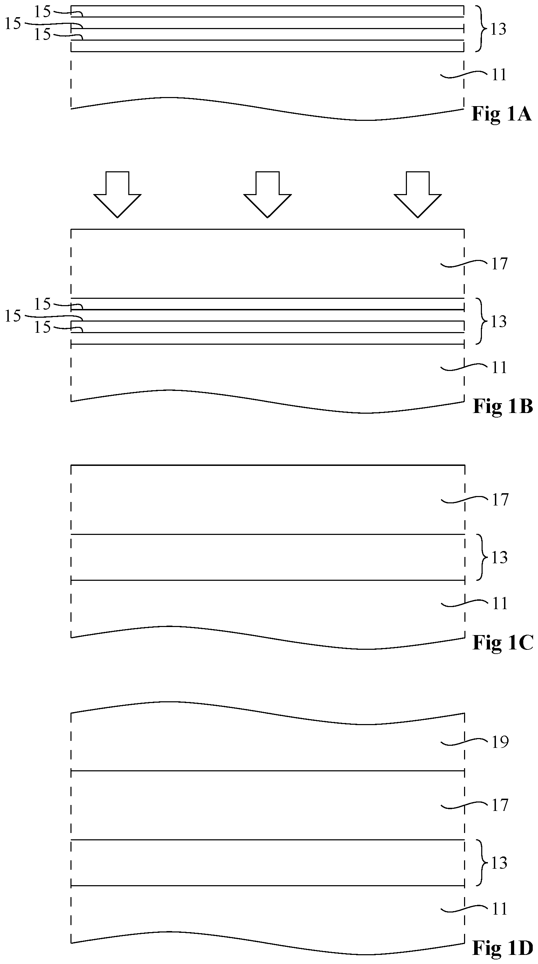

Ces caractéristiques et avantages, ainsi que d'autres, seront exposés en détail dans la description suivante de modes de réalisation particuliers faite à titre non limitatif en relation avec les figures jointes, parmi lesquelles les figure 1A, figure 1B, figure 1C et figure 1D sont des vues en coupe, schématiques et partielles, illustrant des étapes successives d'un exemple d'un procédé de fabrication d'un dispositif électronique à base d'un matériau semiconducteur selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les étapes de fabrication du dispositif électronique postérieures à la réalisation d'une couche en un matériau semiconducteur ainsi que les diverses applications susceptibles de tirer profit d'un tel dispositif n'ont pas été détaillées, les modes de réalisation décrits étant compatibles avec les étapes usuelles de fabrication d'un dispositif électronique à partir d'une couche en un matériau semiconducteur et avec les applications usuelles utilisant de tels dispositifs.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 11 % près, de préférence à 5 % près.

Les figure 1A, figure 1B, figure 1C et figure 1D sont des vues en coupe, schématiques et partielles, illustrant des étapes successives d'un exemple d'un procédé de fabrication d'un dispositif électronique à base d'un matériau semiconducteur selon un mode de réalisation.

À titre d'exemple, les étapes décrites ci-dessous en relation avec les figures 1A à 1D font partie d'un procédé de réalisation d'un filtre radiofréquence de type SAW (de l'anglais « Surface Acoustic Wave » - onde acoustique de surface) ou BAW (de l'anglais « Bulk Acoustic Wave » - onde acoustique de volume), d'un transistor de puissance HEMT (de l'anglais « High Electron Mobility Transistor » - transistor à haute mobilité électronique), d'un dispositif de type laser ou LED (de l'anglais « Light-Emitting Diode » - diode électroluminescente), d'un capteur de type oscillateur poutre, d'un capteur thermique, etc. ou, plus généralement, de tout type de procédé de fabrication d'un dispositif électronique comprenant au moins une région en un matériau semiconducteur inorganique, par exemple un matériau semiconducteur III-N. À titre de variante, les étapes ci-dessous peuvent s'appliquer à la formation d'une couche de revêtement, par exemple une couche tribologique, par exemple à base de nitrure d'aluminium.

La figure 1A illustre plus particulièrement une structure obtenue à l'issue d'une étape de formation, sur une face d'un substrat de support 11 (la face supérieure du substrat de support 11, dans l'orientation de la figure 1A), d'une couche 13 en un dichalcogénure de métal de transition (« Transition Métal Dichalcogenide » - TMD, en anglais).

Le substrat de support 11 peut être en un matériau quelconque, par exemple le silicium, le saphir, le carbure de silicium, le nitrure de silicium, l'alumine, le nitrure d'aluminium, le verre borosilicate, etc. Le substrat de support 11 est par exemple une plaquette en silicium monocristallin présentant un diamètre compris entre 50 et 300 mm, par exemple égal à environ 200 mm, dont la face supérieure est orientée (100). À titre de variante, le substrat de support 11 est de type SOI (de l'anglais « Silicon On Insulator » - silicium sur isolant) et comprend une couche en silicium revêtue d'une couche en dioxyde de silicium elle-même revêtue d'une autre couche en silicium. Par ailleurs, le substrat de support 11 peut comprendre des éléments actifs non représentés en figure 1A, tels que des transistors, ou présenter une structure réfléchissante, par exemple de type miroir de Bragg.

Selon l'application visée, le substrat de support 11 peut être non intentionnellement dopé ou peut, à titre de variante, présenter un niveau de dopage lui conférant par exemple des propriétés thermiques et/ou électriques spécifiques.

Par ailleurs, bien que la figure 1A illustre un exemple dans lequel le substrat de support 11 présente des faces inférieure et supérieure sensiblement planes et parallèles entre elles, cet exemple n'est pas limitatif, les faces inférieure et supérieure du substrat 11 pouvant, à titre de variante, présenter chacune une forme quelconque. À titre d'exemple, la face supérieure du substrat de support 11 peut être non plane, et peut par exemple présenter un relief adapté à la réalisation ultérieure de diodes électroluminescentes verticales, par exemple une forme « en escalier » comprenant des aspérités et des parties en saillie.

Dans l'exemple illustré en figure 1A, la couche 13 en dichalcogénure de métal de transition présente une structure lamellaire ou stratifiée comprenant, depuis la face supérieure du substrat de support 11, un empilement vertical de plusieurs feuillets 15 sensiblement parallèles à la face supérieure du substrat de support 11 et liés entre eux par des liaisons de van der Waals. Chacun des feuillets 15, également appelés couches bidimensionnelles, couches 2D ou monocouches, présente par exemple un arrangement hexagonal des atomes du métal de transition auxquels sont liés, par des liaisons covalentes, les atomes de chalcogène. Dans l'orientation de la figure 1A, le feuillet 15 inférieur de l'empilement, c'est-à-dire le feuillet 15 le plus proche du substrat de support 11, est par exemple en outre lié à la face supérieure du substrat de support 11 par des liaisons de van der Waals et/ou par des liaisons covalentes. Bien que quatre feuillets 15 aient été symbolisés en figure 1A, cet exemple n'est pas limitatif et la couche 13 peut comporter un nombre quelconque de feuillets 15, par exemple compris entre un et cinquante.

Le dichalcogénure de métal de transition présente une formule chimique de type MX₂, où M représente le métal de transition et X l'élément chalcogène. Le métal de transition M est par exemple choisi parmi le molybdène, le tungstène, le vanadium, le niobium, le tantale, le titane, le zirconium, le hafnium et les alliages de ces métaux. L'élément chalcogène X est par exemple choisi parmi le soufre, le sélénium et le tellure. À titre d'exemple, le dichalcogénure de métal de transition est un disulfure de métal de transition présentant une formule chimique de type MS₂, par exemple le disulfure de molybdène (MoS₂), le disulfure de tungstène (WS₂) ou le disulfure de vanadium (VS₂).

La couche 13 en dichalcogénure de métal de transition est par exemple formée par dépôt, par exemple par ALD (de l'anglais « Atomic Layer Déposition » - dépôt de couches atomiques), par exemple selon le procédé décrit dans le brevet français n° 3016889, ou par CVD (de l'anglais « Chemical Vapor Déposition » - dépôt chimique en phase vapeur) du côté de la face supérieure du substrat de support 11. À titre de variante, la couche 13 en dichalcogénure de métal de transition peut d'abord être formée sur une face d'un substrat de report, ou poignée, puis reportée sur la face supérieure du substrat de support 11.

À titre d'exemple, une couche amorphe en disulfure de molybdène revêtant la face supérieure du substrat de support 11 est d'abord formée par ALD à une température égale à environ 90 °C. Cette couche amorphe est par exemple ensuite sulfurée, par exemple par exposition à de l'éthanedithiol (EDT) à une température égale à environ 450 °C, de sorte à modifier, ou corriger, sa stoechiométrie. Enfin, un recuit de cristallisation sous diazote, par exemple à un débit de l'ordre de 2 L.min⁻¹, sous pression atmosphérique, à une température égale à environ 900 °C et pendant une durée de l'ordre de 30 s, est mis en oeuvre de sorte à former les feuillets 15 de la couche 13. Dans le cas où le substrat de support 11 est en silicium, le substrat 11 peut, préalablement à la formation de la couche 13 en dichalcogénure de métal de transition, être oxydé depuis sa face supérieure jusqu'à une profondeur par exemple de l'ordre de 500 nm.

La figure 1B illustre plus particulièrement une structure obtenue à l'issue d'une étape ultérieure de formation d'une couche 17 en un matériau semiconducteur III-N sur la structure obtenue à l'issue des étapes précédemment décrites en relation avec la figure 1A.

Dans l'exemple représenté, la couche 17 en matériau semiconducteur III-N revêt la face de la couche 13 en dichalcogénure de métal de transition opposée au substrat de support 11 (la face supérieure de la couche 13, dans l'orientation de la figure 1B). À titre d'exemple, la couche 17 présente une épaisseur comprise entre 0,15 et 50 nm, de préférence comprise entre 1 et 6 nm, par exemple égale à environ 5 nm. Le matériau de la couche 17 est un nitrure d'au moins un élément du treizième groupe du tableau périodique des éléments, également appelé groupe IIIB dans le système IUPAC et groupe IIIA dans le système CAS, par exemple l'aluminium, le gallium ou l'indium. Le matériau de la couche 17 est par exemple un composé III-N binaire, par exemple le nitrure d'aluminium ou le nitrure de gallium, ou un composé ternaire, par exemple le nitrure d'indium-gallium, ou encore un alliage à base de nitrure d'aluminium, par exemple un composé présentant une formule chimique de type Al_{(1-α)}X_{α}N, où X est un élément quelconque du tableau périodique, par exemple le scandium, l'yttrium, le lanthane, le magnésium, le titane, le vanadium, le chrome ou le molybdène, et où α varie entre 0 et 0,5, de préférence entre 0,03 et 0,2. À titre de variante, le matériau de la couche 17 est un composé quaternaire, par exemple le nitrure d'indium-aluminium-gallium (InGaN:Al).

Par ailleurs, dans le cas où la couche 17 est en un matériau semiconducteur III-N ternaire ou quaternaire, la couche 17 peut présenter, depuis la face supérieure de la couche lamellaire 13, un gradient de concentration en au moins l'un des éléments du composé, par exemple l'un des éléments du treizième groupe. À titre d'exemple, la couche 17 peut être en AlGaN et présenter une teneur en gallium croissante à mesure que l'on s'éloigne de la couche 13.

Dans le cas où la couche 17 est en nitrure d'aluminium, le matériau de la couche 17 est par exemple cristallisé en structure wurtzite à maille hexagonale, les hexagones étant orientés (002) le long d'une direction orthogonale à la face supérieure du substrat de support 11.

La couche 17 en matériau semiconducteur III-N est par exemple formée par dépôt physique en phase vapeur (« Physical Vapor Déposition » - PVD, en anglais), par exemple selon le procédé décrit dans le brevet français n° 3105591. À titre d'exemple, la couche 17 est réalisée par pulvérisation cathodique à une température de l'ordre de 350 °C. Un plasma d'argon et de diazote est par exemple formé puis accéléré, par exemple au moyen d'une source de courant continu, en direction d'une cible en aluminium. Sous l'action du plasma, des atomes d'aluminium sont arrachés de la cible. Ces atomes réagissent avec le diazote du plasma et forment un nitrure d'aluminium se déposant sur la couche 13 en dichalcogénure de métal de transition. Le substrat de support 11 n'est par exemple soumis à aucune tension de polarisation pendant la formation de la couche 17 pour éviter d'endommager la couche 13. À titre de variante, la couche 17 en matériau semiconducteur peut être formée par PLD (de l'anglais « Pulsed Laser Déposition » - ablation laser pulsé).

La figure 1B illustre en outre une étape ultérieure de traitement thermique, ou recuit, de la structure comprenant le substrat de support 11 et les couches 13 et 17. L'étape de traitement thermique, symbolisée par des flèches verticales en figure 1B, vise à accroître la cohésion interne de la couche 13 ainsi que l'adhésion de la couche 13 au substrat de support 11, le substrat 11 n'étant pas destiné à être retiré lors d'étapes ultérieures du procédé de fabrication du dispositif. Au cours du traitement thermique, les liaisons de van der Waals entre les feuillets 15 adjacents de la couche 13 sont transformées en liaisons covalentes, présentant des énergies de liaison supérieures à celles des liaisons de van der Waals reliant initialement les feuillets 15 adjacents entre eux. De façon analogue, les liaisons de van der Waals entre le feuillet 15 inférieur de la couche 13 et le substrat 11 peuvent être transformées en liaisons covalentes au cours de cette étape.

Le traitement thermique est par exemple effectué sous atmosphère azotée en ambiance réductrice, par exemple par nitruration thermique en présence d'un gaz azoté tel que l'ammoniac (NH₃), le diazote ou un oxyde d'azote de type NOₓ, ou en présence d'un ergol azoté, par exemple l'hydrazine (N₂H₄), ou encore en présence d'un gaz ou d'un mélange de gaz adapté à nitrurer la couche 13 à travers la couche 15, par exemple un mélange de diazote et de dihydrogène. La nitruration permet de transformer au moins partiellement le dichalcogénure de métal de transition de la couche 13 en nitrure ou en oxynitrure dudit métal de transition, par exemple de transformer au moins partiellement le disulfure de molybdène en nitrure de molybdène (MoN). En fonction du budget thermique appliqué, la conversion des liaisons de van der Waals en liaisons covalentes peut conduire à la formation de métal de transition métallique seul ou de métal de transition au moins partiellement nitruré, par exemple de molybdène métallique ou de molybdène partiellement nitruré dans le cas où la couche 13 est en MoS₂.

À titre de variante, le traitement thermique peut être effectué sous atmosphère de dihydrogène. Dans ce cas, la couche 13 est par exemple au moins partiellement transformée en billes métalliques à base du métal de transition de la couche 13, par exemple en billes de molybdène métallique.

Le traitement thermique est par exemple réalisé dans un four à une température comprise entre 300 et 1 300 °C, de préférence entre 800 et 1 000 °C. La pression à l'intérieur du four est par exemple inférieure ou égale à 1 bar, par exemple de l'ordre de 400 mbar. À titre de variante, la pression à l'intérieur du four peut être hyperbare. Une assistance plasma peut par ailleurs être prévue, par exemple un plasma de type CCP (de l'anglais « Capacitively Coupled Plasma » - plasma à couplage capacitif) 1 000 W 2,67 mbar N₂/H₂ à 500 °C. De manière plus générale, l'étape illustrée en figure 1B correspond à la mise en oeuvre d'un traitement thermo-chimique.

À titre d'exemple, le recuit est effectué :
- à une température égale à environ 1 000 °C, pendant une durée égale à environ 1 h, à une pression d'ammoniac de l'ordre de 150 mbar et sous un flux d'environ 3 L.min⁻¹ ;
- à une température égale à environ 1 000 °C, pendant une durée égale à environ 10 min, à une pression d'ammoniac de l'ordre de 400 mbar et sous un flux d'environ 3 L.min⁻¹ ;
- à une température égale à environ 800 °C, pendant une durée égale à environ 10 min, à une pression d'ammoniac de l'ordre de 400 mbar et sous un flux d'environ 3 L.min⁻¹ ; ou
- à une température égale à environ 1 000 °C, pendant une durée égale à environ 1 h, à une pression d'ammoniac de l'ordre de 50 mbar et sous un flux d'environ 0,05 L.min⁻¹.

La figure 1C illustre plus particulièrement une structure obtenue à l'issue de l'étape de traitement thermo-chimique précédemment décrite en relation avec la figure 1B.

Comme illustré en figure 1C, le traitement thermo-chimique conduit par exemple à une réorganisation cristalline de la couche 13, se présentant initialement sous la forme d'un empilement de feuillets bidimensionnels 15, en une structure tridimensionnelle. Cela permet avantageusement de maintenir mécaniquement la couche 17 en matériau semiconducteur III-N sur le substrat de support 11, la couche 17 étant solidarisée au substrat 11 par l'intermédiaire de la couche 13.

La figure 1D illustre plus particulièrement une structure obtenue à l'issue d'une étape ultérieure et optionnelle de reprise d'épitaxie sur la couche 17 en matériau semiconducteur III-N.

Dans l'exemple représenté, une couche 19 revêt la face de la couche 17 en matériau semiconducteur III-N opposée au substrat de support 11 (la face supérieure de la couche 17, dans l'orientation de la figure 1D). À titre d'exemple, la couche 19 est en un matériau semiconducteur III-V, par exemple un matériau choisi parmi la liste des matériaux susmentionnés pour la couche 17, par exemple le nitrure d'aluminium. La couche 19 est par exemple en le même matériau que la couche 17 et peut comprendre en outre un élément de transition, par exemple le scandium, ou un autre composé dopant, par exemple du magnésium-zirconium (MgZr), permettant par exemple de modifier les propriétés mécaniques et acoustiques de la couche 19. À titre d'exemple, le matériau de la couche 19 est un composé III-V binaire, par exemple le phosphure d'indium, l'arséniure de gallium ou l'arséniure d'indium, un composé III-V ternaire ou un composé III-V quaternaire, par exemple choisi parmi ceux mentionnés précédemment pour la couche 17.

De façon analogue à la couche 17, la couche 19 peut présenter un gradient de concentration en au moins l'un des éléments du composé.

À titre de variante, par exemple pour des applications dans le domaine de l'électronique de puissance, la couche 19 peut être en carbure de silicium.

La couche 19 présente par exemple une épaisseur supérieure à celle de la couche 17. À titre d'exemple, la couche 19 présente une épaisseur supérieure à 100 nm.

La couche 19 est par exemple formée de manière identique ou analogue à la couche 17, par exemple par PVD, par exemple selon le procédé décrit dans le brevet français n° 3105591. Le substrat de support 11 est par exemple soumis à une tension de polarisation pendant la formation de la couche 19. À titre de variante, le matériau semiconducteur III-N de la couche 19 peut être déposé par MOCVD (de l'anglais « Metalorganic Chemical Vapor Déposition » - dépôt chimique organométallique en phase vapeur), par exemple à une température de l'ordre de 1 100 °C. À titre de variante, la couche 19 est formée par PLD ou par CVD inorganique, par exemple par CVD au chlore.

À titre d'exemple, l'étape de formation de la couche 19 sur la couche 17 est mise en oeuvre dans un délai le plus court possible après avoir effectué l'étape de traitement thermique. Cela permet avantageusement d'éviter ou de limiter l'oxydation du matériau de la couche 17, donc d'obtenir une couche 19 de qualité cristalline optimale. À titre de variante, une étape de traitement désoxydant et/ou de conservation de la couche 17 sous atmosphère non oxydante peut être prévue.

Bien que cela n'ait pas été représenté en figure 1D, une ou plusieurs autres couches, par exemple à base de matériaux semiconducteurs III-V ou de carbure de silicium, peuvent ultérieurement être formées sur la couche 19, par exemple de sorte à former un ou plusieurs puits quantiques, un gaz d'électrons bidimensionnel, etc. À titre d'exemple, dans le cas où la couche 17 est en nitrure d'aluminium, la couche 19 est par exemple en nitrure d'aluminium et peut être revêtue d'une autre couche en nitrure d'aluminium-gallium elle-même revêtue d'encore une autre couche en nitrure de gallium.

Des étapes ultérieures du procédé de fabrication du dispositif électronique peuvent ensuite être mises en oeuvre à partir de la structure de la figure 1D, le substrat de support 11 étant destiné à être conservé à l'issue de ces étapes. À titre d'exemple, des étapes de photolithographie puis gravure et/ou de dépôt peuvent être mises en oeuvre à partir de la structure illustrée en figure 1D.

Un avantage du procédé décrit ci-dessus en relation avec les figures 1A à 1D réside dans le fait que la structure de la couche 13 en dichalcogénure de métal de transition permet d'absorber des contraintes induites par un désaccord de paramètre de maille entre le matériau de la couche 15 et celui de la couche 13. Le fait de prévoir la couche 13 permet en outre de former la couche 17, et éventuellement la couche 19, sur n'importe quel type de substrat de support 11. Cela présente notamment l'avantage de permettre de s'affranchir de l'utilisation d'un substrat en silicium monocristallin. Il en résulte une diminution de coût du dispositif électronique obtenu selon ce procédé.

Un autre avantage du procédé décrit ci-dessus en relation avec les figures 1A à 1D réside dans le fait que la structure lamellaire de la couche 13 en dichalcogénure permet d'améliorer la texturation cristalline des couches 17 et 19, notamment l'orientation préférentielle [002] de la maille hexagonale des III-N perpendiculaire à la surface de croissance. Le fait de prévoir la couche 13 permet de former les couches 17 et 19 texturées, sur n'importe quel type de substrat de support 11. Cela présente notamment l'avantage de permettre de s'affranchir de l'utilisation d'une relation d'épitaxie entre un substrat monocristallin et un III-N. Il en résulte une diminution de coût du dispositif électronique obtenu selon ce procédé.

Un autre avantage du procédé décrit ci-dessus en relation avec les figures 1A à 1D tient au fait que l'étape de traitement thermique permet d'éviter l'apparition d'un phénomène de délamination entre la couche 13 et le substrat de support 11, ou entre les feuillets 15 de la couche 13, lors de la formation de la couche 19. Il en résulte une amélioration de la résistance mécanique du dispositif obtenu selon ce procédé.

Bien que l'on ait décrit ci-dessus un mode de réalisation dans lequel la couche 13 est en dichalcogénure de métal de transition, cet exemple n'est pas limitatif et la couche 13 peut, à titre de variante, être en tout type de matériau chalcogénure ou dichalcogénure lamellaire. À titre d'exemple, la couche 13 peut être en un chalcogénure ou monochalcogénure lamellaire, par exemple en chalcogénure de métal de transition présentant une formule chimique de type MX (M représentant le métal de transition et X l'élément chalcogène) ou en chalcogénure de métal pauvre, par exemple le sulfure de zinc, le sulfure d'étain ou le disulfure d'étain.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus. En particulier, les modes de réalisation décrits ne se limitent pas aux exemples particuliers de matériaux et de dimensions mentionnés ci-dessus.

## Revendications

1. Procédé de fabrication d'un dispositif électronique, comprenant les étapes successives suivantes :
a) former, sur une face d'un substrat de support (11), une première couche (13) en un matériau choisi parmi un dichalcogénure lamellaire ou un chalcogénure lamellaire comprenant un empilement de feuillets (15) ;
b) former, par dépôt physique en phase vapeur du côté de ladite face du substrat de support, une deuxième couche (17) en un premier matériau semiconducteur III-N revêtant la première couche (13) ; et
c) effectuer un traitement thermo-chimique de la première couche (13) conduisant, dans la première couche (13), à une conversion de liaisons de van der Waals entre les feuillets (15) de la première couche en liaisons covalentes.

2. Procédé selon la revendication 1, dans lequel, à l'étape c), le traitement thermo-chimique est un recuit effectué sous atmosphère réductrice.

3. Procédé selon la revendication 1 ou 2, dans lequel, à l'étape c), le traitement thermo-chimique est effectué sous atmosphère azotée, de préférence sous atmosphère d'ammoniac ou de diazote.

4. Procédé selon la revendication 1 ou 2, dans lequel, à l'étape c), le traitement thermo-chimique est effectué sous atmosphère de dihydrogène.

5. Procédé selon l'une quelconque des revendications 1 à 4, dans lequel, à l'étape c), le traitement thermo-chimique conduit en outre à une conversion de liaisons de van der Waals en liaisons covalentes entre la première couche (13) et le substrat de support (11).

6. Procédé selon l'une quelconque des revendications 1 à 5, dans lequel le premier matériau semiconducteur est le nitrure d'aluminium.

7. Procédé selon l'une quelconque des revendications 1 à 6, dans lequel le premier matériau semiconducteur III-N est dopé, de préférence par des atomes de scandium.

8. Procédé selon l'une quelconque des revendications 1 à 7, comprenant en outre, après l'étape c), une étape d) de formation d'une troisième couche (19) en un deuxième matériau semiconducteur revêtant la deuxième couche (17), la troisième couche (19) présentant une épaisseur supérieure à celle de la deuxième couche.

9. Procédé selon la revendication 8, dans lequel le deuxième matériau semiconducteur est un matériau semiconducteur III-V, de préférence III-N.

10. Procédé selon la revendication 8, dans lequel le deuxième matériau semiconducteur est le carbure de silicium.

11. Procédé selon la revendication 8 ou 9, dans lequel le deuxième matériau semiconducteur est identique au premier matériau semiconducteur.

12. Procédé selon l'une quelconque des revendications 8 à 11, dans lequel la troisième couche (19) est dopée.

13. Procédé selon l'une quelconque des revendications 8 à 12, comprenant en outre, après l'étape d), une étape e) de formation d'au moins une quatrième couche revêtant la troisième couche (19).

14. Procédé selon l'une quelconque des revendications 1 à 13, dans lequel, à l'étape c), le traitement thermo-chimique s'accompagne d'un traitement par plasma.

15. Procédé selon l'une quelconque des revendications 1 à 14, dans lequel la première couche (13) est en dichalcogénure de métal de transition, de préférence en disulfure de molybdène ou en disulfure de tungstène.

16. Procédé selon l'une quelconque des revendications 1 à 15, dans lequel, à l'étape c), le traitement thermo-chimique est effectué à une température comprise entre 300 et 1 500 °C, de préférence comprise entre 800 et 1 000 °C.

17. Procédé selon l'une quelconque des revendications 1 à 16, dans lequel la deuxième couche présente une épaisseur comprise entre 0,15 et 50 nm, de préférence comprise entre 1 et 6 nm.
